# EUROPEAN PATENT SPECIFICATION

(11) **EP 3 456 856 B1**
(45) Date of publication and mention of the grant of the patent: **07.04.2021**
(21) Application number: 17737459.2
(22) Date of filing: 03.02.2017
(51) Int. Cl.: C23C 14/04, H01L 51/56, C23C 14/12, H01L 51/00

(54) **MASK PLATE**
MASKE
PLAQUE DE MASQUE

(30) Priority: 09.05.2016 CN 201620413388 U
(43) Date of publication of application: 20.03.2019
(73) Proprietor: BOE Technology Group Co., Ltd., Beijing 100015 (CN); Ordos Yuansheng Optoelectronics Co., Ltd., Ordos, Inner Mongolia 017020 (CN)
(72) Inventor: LV, Shouhua, Beijing 100176 (CN); SUN, Pu, Beijing 100176 (CN)
(74) Representative: Potter Clarkson
(86) International application number: PCT/CN2017/072806
(87) International publication number: WO 2017/193646

(56) References cited:
- CN-A- 103 390 728
- CN-A- 103 911 583
- CN-U- 205 576 262
- US-A1- 2011 157 575
- US-A1- 2011 229 633
- US-A1- 2014 065 355
- US-A1- 2014 065 355
- US-A1- 2014 150 721
- US-B2- 8 881 676

## Description

### TECHNICAL FIELD

The present invention relates to the field of OLED display technology, and more particularly to a mask.

### BACKGROUND

An Organic Light-Emitting Diode (OLED) device has many advantages such as self-luminous, fast response time, wide viewing angle, low cost, simple manufacturing process, high resolution and high brightness. It is considered as an emerging application technology for next generation flat panel display.

According to the organic vapor deposition film technology for the OLED, a high precision mask is used as a mold, after volatilizing at high temperature, the organic material in molecular state is evaporated on the back glass through mask openings of an effective open region on the mask. Thus an organic light emitting layer for achieving organic light emission is formed. The mask typically includes a plurality of mask strips and a mounting frame. Specially, after each mask strip is stretched by a clamp to adjust its parameters to meet the requirements, the mask strip is affixed and secured to the surface of the mounting frame.

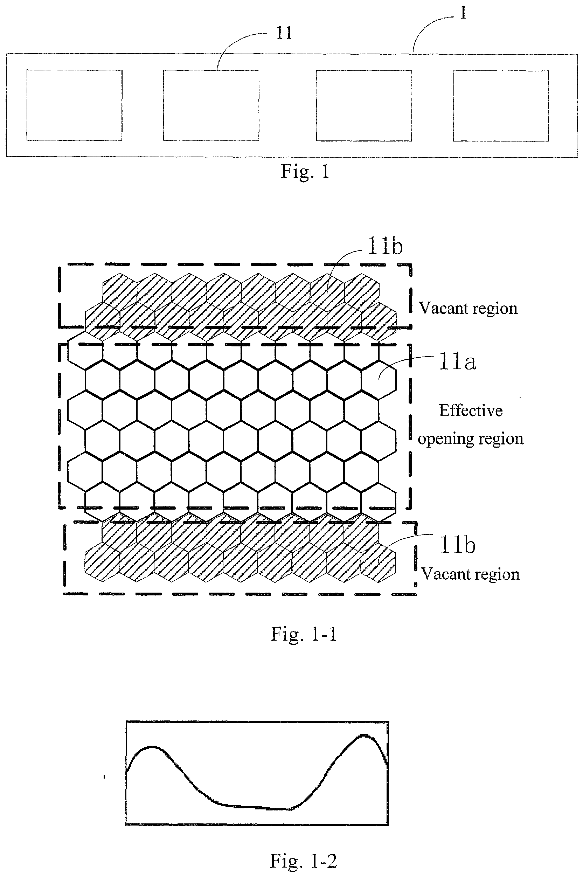

Referring to Fig. 1, each mask strip 1 is provided with a plurality of mask units (cells) 11. Referring to Fig. 1-1, each mask unit 11 includes an effective opening region and two vacant regions (which may be referred to as dummy regions). Mask openings 11a are provided in the effective opening region. The two vacant regions are respectively provided on both sides of the effective opening region perpendicular to a stretching direction and close to the effective opening region. The vacant region is provided with vacant openings 11b.

As shown in Fig. 1-1, there is shown a schematic view of a masking unit of masking strip in related art. The mask openings 11a in the effective opening region and the vacant openings 11b in the vacant region are porous (i.e., the mask strip is a slot-type mask strip). However, in the process of using a mask including a mask strip composed of the mask units shown in Fig. 1-1, it has been found that the edge of the mask strip is downwardly curled during the adjustment of being stretched by the clamp (as shown in Fig. 1-2). The greater the tensile strength, the more severe the curl deformation. In the vapor deposition process, a *shadow* effect will occur at the edge of the mask unit due to this kind of curling. That will eventually lead to poor color mixing at edges of the display panel in the vapor deposition process, thus the product yield is not high.

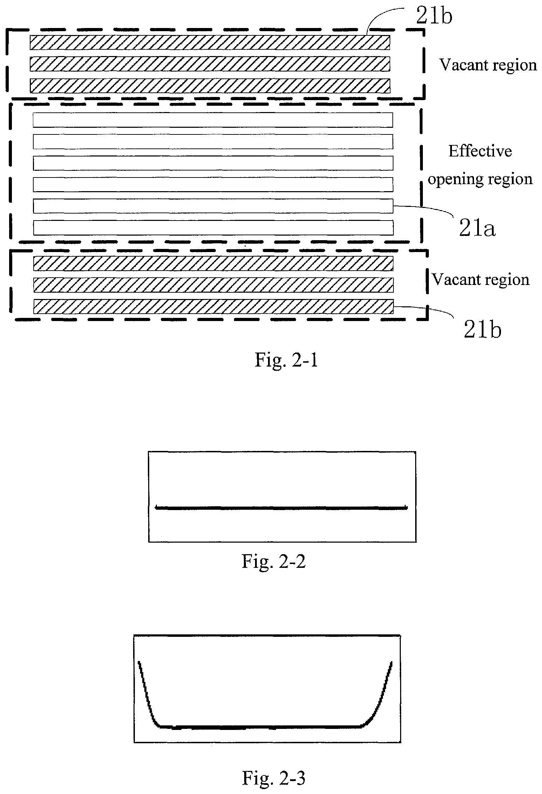

As shown in Fig. 2-1, there is shown a schematic view of another masking unit of masking strip in related art. The mask openings 21a in the effective opening region and the vacant openings 21b in the vacant region are thin strips (i.e., the mask strip is a slit-type mask strip). However, in the process of using a mask plate including a mask strip composed of the mask units shown in Fig. 2-1, it has been found that, during the adjustment of being stretched by the clamp, the mask strip will not be a large deformation if the tension of the mask strip is within a certain range (as shown in Fig. 2-2). The mask strip would be upwardly curled when the tension gradually increased beyond a certain range (as shown in Fig. 2-3). Similarly, in the vapor deposition process, a *shadow* effect will occur at the edge of the mask unit due to this kind of curling. That will eventually lead to poor color mixing at edges of the display panel in the vapor deposition process, thus the product yield is not high.

US 8 881 676 discloses a mask frame assembly for depositing a deposition material on a deposition substrate comprising a mask frame including an opening and frames surrounding the opening, and a mask coupled on the mask frame. A deformation prevention unit is formed on at least one region of the mask. Since the deformation prevention unit is formed on a peripheral portion of a deposition pattern in the mask, deformation of the mask in a vertical direction may be reduced. US2014/0150721 discloses a mask frame assembly for thin film deposition including a mask frame having an opening, and a mask configured to be coupled to the mask frame and including a first surface for facing a deposition substrate, a second surface opposite the first surface, and a deformation prevention part having varying thicknesses.

### SUMMARY

In order to at least partly solve the technical problem existing in the related art, embodiments of the present invention provide a mask, which may prevent curling of the mask strips in the stretching process, and the shadow effect at the edge of the mask unit can be suppressed, thereby poor color mixing at edges of the display panel in the vapor deposition process can be avoided. The product yield may be improved. The invention is disclosed in the appended claims.

According to an embodiment of the present invention, there is provided a mask, including: a plurality of mask strips and a mounting frame, the plurality of mask strips being mounted on a mounting frame after being stretched, each mask strip comprising a plurality of mask units, each mask unit comprising an effective opening region and two vacant regions, mask openings being disposed in the effective opening region, the two vacant regions being respectively provided on both sides of the effective opening region perpendicular to a stretching direction and close to the effective opening region, vacant openings being disposed in the vacant regions, wherein contour shape of each mask opening is different from that of each vacant opening and stress generated by the mask openings and stress generated by the vacant openings in the stretching process can be mutually compensated.

In one embodiment, the contour shape of each mask opening is such that it provides for a porous effective opening region and the contour shape of each vacant opening is a thin strip shape, and a lengthwise direction of the vacant openings is substantially parallel to the stretching direction.

In one embodiment, the lengthwise direction of the vacant openings is parallel to the stretching direction.

In one embodiment, the contour shape of the mask opening is a thin strip shape and the contour shape of the vacant opening is such that it provides for a porous effective opening region, and a lengthwise direction of the mask openings is substantially parallel to the stretching direction.

In one embodiment, the lengthwise direction of the mask openings is parallel to the stretching direction.

In one embodiment, the effective opening region is provided with a plurality of mask openings, the mask openings are of the same shape and size and uniformly distributed, and the vacant regions are provided with a plurality of vacant openings, the vacant openings are of the same shape and size and uniformly distributed,.

In one embodiment, the mask strips are fixed to the mounting frame by welding.

In one embodiment, each of the mask strips is fixed on the mounting frame in a horizontal direction; and the plurality of mask strips are arranged in close proximity to each other in a vertical direction.

In one embodiment, the mask strips are made of metal material.

In one embodiment, the metal material comprises an invar alloy.

The one or more embodiments of the present invention have the following advantages.

According to the mask provided by one or more embodiments of the present invention, the contour shape of the mask opening is provided to be different from that of the vacant opening, so that the stress generated by the mask openings and the stress generated by the vacant openings in the stretching process can be mutually compensated. Therefore, curling of the mask strips in the stretching process can be prevented. The shadow effect at edges of the mask unit can be suppressed; thereby poor color mixing at edges of the display panel in the vapor deposition process can be avoided. The product yield can be improved.

### BRIEF DESCRIPTION OF THE DRAWINGS

The drawings are used to provide a further understanding of the invention and constitute a part of the specification, together with the following detailed description, for purposes of explanation of the invention, but are not to be construed as limiting the invention. In the drawings:
Fig. 1 is a schematic view of a mask strip in related art;
Fig. 1-1 is a schematic view of an example of mask units of a mask strip in Fig. 1;
Fig. 1-2 is a side view showing that curling occurs during the process of a mask strip composed of the mask units shown in Fig. 1-1 being stretched;
Fig. 2-1 is a schematic view of another example of mask units of a mask strip in Fig. 1;
Fig. 2-2 is a side view showing that no curling occurs during the process of a mask strip composed of the mask units shown in Fig. 2-1 being stretched;
Fig. 2-3 is a side view showing that curling occurs during the process of a mask strip composed of the mask units shown in Fig. 2-1 being stretched;

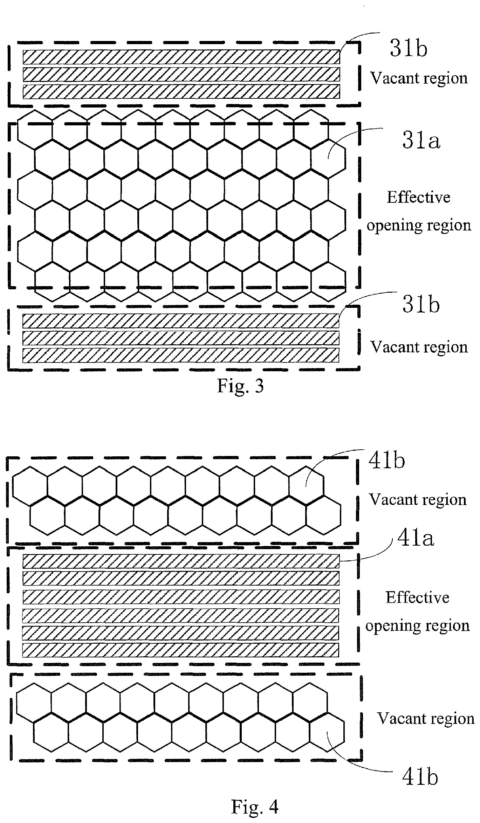

Fig. 3 is a schematic view of mask units of a mask strip provided by embodiments of the present invention; and
Fig. 4 is a schematic view of mask units of another mask strip provided by embodiments of the present invention.

### DETAILED DESCRIPTION

In order to provide a better understanding of the technical solution of the present invention by those skilled in the art, the mask provided by the present invention will be described in detail with reference to the accompanying drawings.

The embodiment of the present invention provides a mask including a plurality of mask strips and a mounting frame, the plurality of mask strips are mounted on a mounting frame after being stretched. Each mask strip includes a plurality of mask units. Each mask unit includes an effective opening region and two vacant regions. Mask openings are disposed in the effective opening region. The two vacant regions are respectively provided on both sides of the effective opening region perpendicular to a stretching direction and close to the effective opening region. Vacant openings are disposed in the vacant regions. Wherein the contour shape of each mask opening is different from that of each vacant opening and the stress generated by the mask openings and the stress generated by the vacant openings in a stretching process can be mutually compensated.

According to the mask provided by one or more embodiments of the present invention, the contour shape of the mask opening is provided to be different from that of the vacant opening, so that the stress generated by the mask openings and the stress generated by the vacant openings in the stretching process can be mutually compensated. Therefore, curling of the mask strips in the stretching process can be prevented. The *shadow* effect at edges of the mask unit can be suppressed; thereby poor color mixing at edges of the display panel in the vapor deposition process can be avoided. The product yield can be improved.

The specific structure of the mask provided by the present invention will be described in detail below with reference to Figs. 3 and 4.

As shown in Fig. 3, according to the mask units in an embodiment, the mask openings 31a in the effective opening region are porous (a slot-type) and the vacant openings 31b in the vacant region are thin strips (a slit-type). The lengthwise direction of the vacant openings 31b is substantially parallel to the direction of stretching, and in particular, when the stretching direction is the horizontal direction in Fig. 3, the lengthwise direction of the vacant openings 31b is substantially parallel to the horizontal direction.

Understandably, according to the mask strip formed by the mask units shown in Fig. 3, since the stress in the effective opening region during the stretching adjustment is directed downward (i.e., perpendicular to the paper and inward the paper) and the stress in the vacant region is directed upward (i.e., perpendicular to the paper and outward the paper), the ability of the mask strip to equalize the stress is enhanced, and the curling of the mask strips in the stretching process can be prevented.

Preferably, the lengthwise direction of the vacant opening 31b is parallel to the stretching direction. In Fig. 3, when the stretching direction is a horizontal direction, the lengthwise direction of the vacant opening 31b is also the horizontal direction.

As shown in Fig. 4, according to the mask units in another embodiment, the mask opening 41a in the effective opening region is a thin strip (a slit-type) and the vacant opening 41b in the vacant region is porous (a slot-type). The lengthwise direction of the mask opening 41a is substantially parallel to the direction of stretching, and in particular, when the stretching direction is the horizontal direction, the lengthwise direction of the mask opening 41a is substantially parallel to the horizontal direction.

Understandably, according to the mask strip formed by the mask units shown in Fig. 4, since the stress in the effective opening region during the stretching adjustment is directed upward (i.e., perpendicular to the paper and outward the paper) and the stress in the vacant region is directed downward (i.e., perpendicular to the paper and inward the paper), the ability of the barrier strip to equalize the stress is enhanced, and the curling of the mask strips in the stretching process can be prevented.

Preferably, the lengthwise direction of the mask opening 41a is parallel to the stretching direction, that is, the lengthwise direction is a horizontal direction.

According to the mask provided by embodiments of the present invention, the effective opening region may be provided with a plurality of mask openings which are of the same shape and size and uniformly distributed. The vacant region may be provided with a plurality of vacant openings which are of the same shape and size and uniformly distributed, as shown in Figs. 3 and 4.

Specifically, the mask strips can be fixed to the mounting frame by welding.

Each of the mask strips may be fixed in the horizontal direction on the mounting frame. A plurality of mask strips are arranged in close proximity to each other in a vertical direction. That is, each of the mask strips is fixed to the mounting frame in order from top to bottom.

Further, since the vapor deposition is often carried out in a high temperature and high pressure environment, in order to avoid serious deformation of the mask strips, the material of the mask strips needs to have advantages such as high-temperature and high-pressure resistant, small thermal expansion coefficient and morphological stability. In particular, the mask strips may be made of metal material. The metal material includes, but is not limited to, an invar alloy.

It should be noted that, Figs. 3 and 4 show two specific implementations of the masking units of the mask strip provided by the present invention, but the present invention is not limited thereto. As long as the contour shape of the mask opening is different from that of the vacant opening and the stresses generated in the stretching process can be compensated for each other, such structures are also within the scope of the present invention.

## Claims

1. A mask, comprising:
a plurality of mask strips and a mounting frame, the plurality of mask strips being mounted on the mounting frame after being stretched, each mask strip comprising a plurality of mask units, each mask unit comprising an effective opening region and two vacant regions, mask openings (31a, 41a) being disposed in the effective opening region, the two vacant regions being respectively provided on both sides of the effective opening region perpendicular to a stretching direction and close to the effective opening region, vacant openings (31b, 41b) being disposed in the vacant regions,
wherein a contour shape of each mask opening (31a, 41a) is different from that of each vacant opening (31b, 41b) and stress generated by the mask openings (31a, 41a) and stress generated by the vacant openings (31b, 41b) in a stretching process can be mutually compensated.

2. The mask of claim 1, wherein the contour shape of each mask opening (31a) is such that it provides for a porous effective opening region and the contour shape of each vacant opening (31b) is a thin strip shape, and a lengthwise direction of the vacant openings (31b) is substantially parallel to the stretching direction.

3. The mask of claim 1, wherein the contour shape of the mask opening (41a) is a thin strip shape and the contour shape of the vacant opening (41b) is such that it provides for a porous effective opening region, and a lengthwise direction of the mask openings (41a) is substantially parallel to the stretching direction.

4. The mask of claim 2, wherein the lengthwise direction of the vacant openings (31b) is parallel to the stretching direction.

5. The mask of claim 3, wherein the lengthwise direction of the mask openings (41a) is parallel to the stretching direction.

6. The mask of claim 1, wherein the effective opening region is provided with a plurality of mask openings (31a, 41a), the mask openings (31a, 41a) are of the same shape and size and uniformly distributed, and
the vacant regions are provided with a plurality of vacant openings (31b, 41b), the vacant openings (31b, 41b) are of the same shape and size and uniformly distributed.

7. The mask of claim 1, wherein the mask strips are fixed to the mounting frame by welding.

8. The mask of claim 1, wherein each of the mask strips is fixed on the mounting frame in a horizontal direction; and
the plurality of mask strips are arranged in close proximity to each other in a vertical direction

9. The mask of any one of claims 1-8, wherein the mask strips are made of metal material.

10. The mask of claim 9, wherein the metal material comprises an invar alloy.

## Patentansprüche

1. Maske, die Folgendes umfasst:
mehrere Maskenstreifen und einen Montagerahmen, wobei die mehreren Maskenstreifen auf den Montagerahmen montiert werden, nachdem sie gestreckt werden, jeder Maskenstreifen mehrere Maskeneinheiten umfasst, jede Maskeneinheit eine wirksame Öffnungsregion und zwei freie Regionen umfasst, Maskenöffnungen (31a, 41a) in der wirksamen Öffnungsregion angeordnet sind, die zwei freien Regionen jeweils auf beiden Seiten der wirksamen Öffnungsregion senkrecht zu einer Streckrichtung und nahe der wirksamen Öffnungsregion bereitgestellt sind, freie Öffnungen (31b, 41b) in den freien Regionen angeordnet sind,
wobei eine Konturform jeder Maskenöffnung (31a, 41a) sich von der jeder freien Öffnung (31b, 41b) unterscheidet und Spannung, die durch die Maskenöffnungen (31a, 41a) in einem Streckvorgang erzeugt wird, und Spannung, die durch die freien Öffnungen (31b, 41b) in einem Streckvorgang erzeugt wird, sich gegenseitig kompensieren können.

2. Maske nach Anspruch 1, wobei die Konturform jeder Maskenöffnung (31a) derart ist, dass sie eine poröse wirksame Öffnungsregion bereitstellt, und die Konturform jeder freien Öffnung (31b) eine dünne Streifenform ist, und eine Längsrichtung der freien Öffnungen (31b) im Wesentlichen parallel zu der Streckrichtung ist.

3. Maske nach Anspruch 1, wobei die Konturform der Maskenöffnung (41a) eine dünne Streifenform ist und die Konturform der freien Öffnung (41b) derart ist, dass sie eine poröse wirksame Öffnungsregion bereitstellt und eine Längsrichtung der Maskenöffnungen (41a) im Wesentlichen parallel zu der Streckrichtung ist.

4. Maske nach Anspruch 2, wobei die Längsrichtung der freien Öffnungen (31b) parallel zu der Streckrichtung ist.

5. Maske nach Anspruch 3, wobei die Längsrichtung der Maskenöffnungen (41a) parallel zu der Streckrichtung ist.

6. Maske nach Anspruch 1, wobei die wirksame Öffnungsregion mit mehreren Maskenöffnungen (31a, 41a) versehen ist, die Maskenöffnungen (31a, 41a) die gleiche Form und Größe haben und gleichmäßig verteilt sind und die freien Regionen mit mehreren freien Öffnungen (31b, 41b) versehen sind, die freien Öffnungen (31b, 41b) von gleicher Form und Größe sind und gleichmäßig verteilt sind.

7. Maske nach Anspruch 1, wobei die Maskenstreifen durch Schweißen an dem Montagerahmen befestigt sind.

8. Maske nach Anspruch 1, wobei jeder der Maskenstreifen in einer horizontalen Richtung auf dem Montagerahmen befestigt ist; und
die mehreren Maskenstreifen in einer vertikalen Richtung in unmittelbarer Nähe zueinander eingerichtet sind.

9. Maske nach einem der Ansprüche 1-8, wobei die Maskenstreifen aus Metallmaterial gefertigt sind.

10. Maske nach Anspruch 9, wobei das Metallmaterial eine Invarlegierung umfasst.

## Revendications

1. Masque, comprenant :
une pluralité de bandes de masque et un cadre de montage, la pluralité de bandes de masque étant montées sur le cadre de montage après avoir été étirées, chaque bande de masque comprenant une pluralité d'unités de masque, chaque unité de masque comprenant une région d'ouverture effective et deux régions vacantes, des ouvertures de masque (31a, 41a) étant disposées dans la région d'ouverture effective, les deux régions vacantes étant respectivement pourvues des deux côtés de la région d'ouverture effective perpendiculaire à une direction d'étirage et à proximité de la région d'ouverture effective, des ouvertures vacantes (31b, 41b) étant disposées dans les régions vacantes,
une forme de contour de chaque ouverture de masque (31a, 41a) étant différente de celle de chaque ouverture vacante (31b, 41b) et la contrainte générée par les ouvertures de masque (31a, 41a) et la contrainte générée par les ouvertures vacantes (31b, 41b) dans un processus d'étirage pouvant être mutuellement compensées.

2. Masque selon la revendication 1, dans lequel la forme de contour de chaque ouverture de masque (31a) est telle qu'elle fournit une région d'ouverture effective poreuse et la forme de contour de chaque ouverture vacante (31b) est une forme de bande mince, et une direction de la longueur des ouvertures vacantes (31b) est sensiblement parallèle à la direction d'étirage.

3. Masque selon la revendication 1, dans lequel la forme de contour de l'ouverture de masque (41a) est une forme de bande mince et la forme de contour de l'ouverture vacante (41b) est telle qu'elle fournit une région d'ouverture effective poreuse, et une direction de la longueur des ouvertures de masque (41a) est sensiblement parallèle à la direction d'étirage.

4. Masque selon la revendication 2, dans lequel la direction de la longueur des ouvertures vacantes (31b) est parallèle à la direction d'étirage.

5. Masque selon la revendication 3, dans lequel la direction de la longueur des ouvertures de masque (41a) est parallèle à la direction d'étirage.

6. Masque selon la revendication 1, dans lequel la région d'ouverture effective est pourvue d'une pluralité d'ouvertures de masque (31a, 41a), les ouvertures de masque (31a, 41a) sont de la même forme et de la même taille et sont uniformément réparties, et
les régions vacantes sont pourvues d'une pluralité d'ouvertures vacantes (31b, 41b), les ouvertures vacantes (31b, 41b) étant de même forme et taille et uniformément réparties.

7. Masque selon la revendication 1, dans lequel les bandes de masque sont fixées au cadre de montage par soudure.

8. Masque selon la revendication 1, dans lequel chacune des bandes de masque est fixée sur le cadre de montage dans une direction horizontale ; et
la pluralité de bandes de masque sont disposées à proximité les unes des autres dans une direction verticale.

9. Masque selon l'une quelconque des revendications 1 à 8, dans lequel les bandes de masque sont en matériau métallique.

10. Masque selon la revendication 9, dans lequel le matériau métallique comprend un alliage d'invar.
